# EUROPEAN PATENT APPLICATION

(11) **EP 4 358 149 A1**
(43) Date of publication of application: **24.04.2024**
(21) Application number: 22202203.0
(22) Date of filing: 18.10.2022
(51) Int. Cl.: H01L 29/06, H01L 29/36, H01L 21/329, H01L 29/872, H01L 29/16

(54) **SEMICONDUCTOR POWER DEVICE WITH IMPROVED JUNCTION TERMINATION EXTENSION**

(71) Applicant: Nexperia B.V., 6534 AB Nijmegen (NL)
(72) Inventor: HABENICHT, Sönke, 22529 Hamburg (DE); MAZZILLO, Massimo Cataldo, 22529 Hamburg (DE); EL-ZAMMAR, Georgio, 22529 Hamburg (DE); URRESTI IBANEZ, Jesus Roberto, 22529 Hamburg (DE); SCHNITT, Wolfgang, 22529 Hamburg (DE)
(74) Representative: Pjanovic, Ilija

(57) **Abstract**

Aspects of the present disclosure relate to a semiconductor power device and to a method for manufacturing the same. Aspects of the present disclosure particularly relate to a merged P-i-N Schottky, MPS, diode, more in particular a Silicon Carbine, SiC, MPS diode.

The semiconductor power device comprises a semiconductor body comprising a conductive substrate and an epitaxial layer of a first charge type grown on the conductive substrate, and one or more inner wells of a second charge type different from the first charge type in an active area of the semiconductor power device.

At least some of the one or more inner wells of the second charge type are formed using at least two ion implantation steps. One step is dedicated to forming the inner wells of the second type whereas one or more further ion implantation steps are simultaneously used for forming a respective JTE structure and for increasing a dopant concentration of at least one well of the second charge type.

## Description

### FIELD

Aspects of the present disclosure relate to a semiconductor power device and to a method for manufacturing the same. Aspects of the present disclosure particularly relate to a Merged P-i-N Schottky, MPS, diode, more in particular a Silicon Carbide, SiC, MPS diode.

### BACKGROUND

SiC semiconductor power devices are confronted with various requirements concerning avalanche ruggedness and unclamped-inductive switching, UIS, performance. For this reason, the termination area adjacent the active area of the device plays a vital role to control the breakdown in avalanche into the active area of the chip area. In this case, the effective chip area participating in taking the avalanche current is maximized, which results in an optimized UIS-ruggedness behavior.

The termination area typically comprises a junction termination extension, JTE, of a charge type that is different from a remaining part of the epitaxial layer the JTE is arranged in. The JTE can be in the form of a single relatively large well, hereinafter referred to as JTE border, that can be supplemented by one or more further JTE borders that are more remote from the active area of the semiconductor power device than the JTE border. Alternatively, the JTE can be in the form of a plurality of mutually separated rings, hereinafter referred to as JTE rings. It is noted that combinations of a JTE border, further JTE border, and JTE rings are also known.

The design of the JTE often leads to an unstable and difficult to control behavior in terms of breakdown between the termination area and the active area. This is because typical process parameters, such as the implantation dose for creating the (further) JTE border or JTE rings, simultaneously affect the breakdown in the termination area and the active area, thus making it difficult to steer the breakdown at the termination area and the active area individually.

### SUMMARY

Aspects of the present disclosure relate to a method for manufacturing a semiconductor power device. This method comprises providing a semiconductor body that includes a conductive substrate and an epitaxial layer of a first charge type grown on the conductive substrate, and forming, by ion implantation, one or more inner wells of a second charge type different from the first charge type in an active area of the semiconductor power device. The method further comprises forming a termination area of the semiconductor power device separated from the one or more inner wells by forming a JTE border of a second charge type by ion implantation. Optionally, at least one of a further JTE border and a plurality of JTE rings is additionally formed by ion implantation. The further JTE border, when formed, is of the second charge type and partially overlaps the JTE border in the manufactured semiconductor power device. The JTE rings, when formed, are arranged at least partially in the JTE border and/or further JTE border in the manufactured semiconductor power device and are of the second charge type.

At least one of the ion implantation for forming the JTE border, the ion implantation for forming the further JTE border, and the ion implantation for forming the JTE rings is used for increasing a dopant concentration of at least some of the one or more inner wells of the second charge type.

The breakdown behavior of the semiconductor power device is predominantly determined by the dopant concentration in the various parts of the device. According to an aspect of the present disclosure, at least some but preferably all of the one or more inner wells of the second charge type are formed using at least two ion implantation steps. One step is dedicated to forming the inner wells of the second type whereas one or more further ion implantation steps are simultaneously used for forming a respective JTE structure, e.g. JTE border, further JTE border, or JTE rings, and for increasing a dopant concentration of at least some of the inner wells of the second charge type.

The step of forming the one or more inner wells of the second charge type can be performed using a first ion implantation masking layer, and the step of performing ion implantation for increasing the dopant concentration of at least some of the one or more inner wells of the second charge step can be performed using a second ion implantation masking layer that is aligned with or at least partially identical to the first ion implantation masking layer. The first ion implantation masking layer may comprise one or more first openings through which ions may penetrate the semiconductor body thereby forming the one or more inner wells. The method may further comprise constructing the second ion implantation masking layer by modifying the first ion implantation masking layer, after having formed the one or more inner wells and while the first ion implantation masking layer is still present on the semiconductor body, by creating second openings in the first ion implantation masking layer that correspond to the JTE border, further JTE border and/or JTE rings to be formed. For example, regions of the first ion implantation masking layer that correspond to the JTE border, further JTE border and/or JTE rings to be formed during the subsequent ion implantation step can be opened, for example using known etching techniques, thereby forming one or more second openings. Accordingly, when using the second ion implantation masking layer during ion implantation, ions will be implanted through the one or more first openings thereby increasing a dopant concentration of the one or more inner wells, and ions will be implanted through the one or more second openings thereby forming the JTE border, further JTE border and/or JTE rings. If so desired, the second ion implantation masking layer can be modified by covering some of the one or more first openings. When using such modified second ion implantation masking layer during ion implantation, ions will be implanted through the first openings that are not covered for increasing a dopant concentration of some of the one or more inner wells, and ions will be implanted through the second openings for forming the JTE border, further JTE border and/or JTE rings. Ions will however not be implanted through the first openings that are covered thereby preventing that the dopant concentration of the corresponding inner wells is changed. Covering some of the one or more first openings can be obtained by depositing and subsequent patterning of a masking layer.
In the manner described above, alignment can be achieved between the ion implantation step for forming the one or more inner wells and the ion implantation step for forming the JTE structure(s) and for increasing the dopant concentration of at least some of the inner wells of the second charge type of the manufactured semiconductor power device.

In the embodiment described above, the one or more inner wells are formed before forming the JTE border, further JTE border, and/or JTE rings. However, the present disclosure is not limited thereto. For example, an ion implantation masking layer can be used during an ion implantation step that comprises second openings for forming the JTE border, further JTE border, and/or JTE rings, and first openings for forming the one or more inner wells. Hence, during the ion implantation step using this ion implantation masking layer, part of the one or more inner wells, and the JTE border, further JTE border, and/or JTE rings are formed. Then, the ion implantation masking layer is modified to form a further ion implantation masking layer such that the second openings that were used for forming the JTE border, further JTE border, and/or JTE rings are covered for example using patterned masking material. Hence, when using this modified ion implantation masking layer during a further ion implantation step, the one or more inner wells are formed.

In other embodiments, the ion implantation for forming the one or more inner wells of the second charge type, and the ion implantation for forming the JTE border, the optional JTE rings, and/or the optional further JTE border are performed using different ion implantation masking layers that are separately arranged on the semiconductor body. In contrast to the first ion implantation masking layer described earlier, the first ion implantation masking layer is removed from the semiconductor body before arranging the second ion implantation masking layer. Generally, an ion implantation masking layer can realized by depositing or otherwise providing a layer of masking material and by patterning this layer using lithography techniques.

The method may further comprise forming an outer well simultaneously with forming the one or more inner wells, wherein the outer well partially overlaps with the JTE border in the manufactured semiconductor power device, and wherein the outer well is preferably wider than the inner wells.

The at least one of the ion implantation for forming the JTE border, the ion implantation for forming the further JTE border, and the ion implantation for forming the JTE rings can be used for increasing a dopant concentration of all the inner wells of the second charge type.

In the above, a distinction can be made between a relatively deep ion implantation that defines the depth of the one or more inner wells, and one or more shallow ion implantations by which the dopant concentration is increased in at least some of the one or more inner wells and by which the JTE border, further JTE border, and/or JTE rings are formed. The relatively deep ion implantation is performed using a first ion implantation masking layer, whereas the one or more shallow ion implantations are performed using the same or respective second ion implantation masking layers. According to aspects of the present disclosure, the relatively deep ion implantation can be performed before or after the more shallow ion implantation step(s).

A maximum depth d0 of the one or more inner wells can be greater than a maximum depth d1 of the JTE border, greater than a maximum depth d2 of the further JTE border, and greater than a maximum depth d3 of the JTE rings. In turn, the maximum depth d1 of the JTE border can be greater than the maximum depth d2 of the further JTE border, and greater than the maximum depth d3 of the JTE rings. The maximum depth d2 of the further JTE border can be greater than or equal to the maximum depth d3 of the JTE rings. These depths are calculated with respect to a top surface of the epitaxial layer. In general, and not limited to the example above, typical values are 0.8 <= d0 <= 1.2 micrometer, 0.6 <= d1 <= 0.8 micrometer, 0.4 <= d2 <= 0.6 micrometer, 0.2 <= d3 <= 0.4 micrometer. Alternatively, the values for d1, d2, and d3 can be expressed as percentage ranges relative to depth d0. For example, d1 can lie in a range between 60 and 80 percent of d0, d2 in a range between 40 and 60 percent of d0, and d3 in a range between 20 and 40 percent of d0.

Each ion implantation step causes an increase in dopant concentration in the implanted areas. For example. The ion implantation step for forming the one or more inner wells may raise the dopant concentration in the implanted areas by an amount C0 in the range between 8E17 and 3E18 #/cm3. The ion implantation step for forming the JTE border may raise the dopant concentration by an amount C1 in the range between 1E17 and 5E17 #/cm3. The ion implantation step for forming the further JTE border may raise the dopant concentration by an amount C2 in the range between 5E16 and 1E17 #/cm3. The ion implantation step for forming the JTE rings may raise the dopant concentration by an amount C3 in the range between 1E17 and 1E18 #/cm3. It is noted that a single ion implantation step may be used for forming at least one of the JTE border, the further JTE border, and the JTE rings.

In an embodiment, each of the abovementioned ion implantation steps causes an independent increase in dopant concentration in the one or more inner wells. Furthermore, it is assumed that d3 <= d2 <= d1 <= d0. In this case, the dopant concentration in the one or more inner wells can be described as a function of depth d as:

| Depth | Dopant concentration |
|---|---|
| 0 < d <= d3 | C0+C1+C2+C3 |
| d3 < d <=d2 | C0+C1+C2 |
| d2 < d <= d1 | CO+C1 |
| d1 < d <= d0 | C0 |

Other dopant profiles for the one or more inner wells, in case some ion implantation steps for forming the JTE border, further JTE border, or JTE rings do not increase the dopant concentration in the one or more wells, can be easily found by setting the corresponding increase in dopant concentration, e.g. C1, C2, C3, to zero.

The semiconductor power device may comprise a Merged P-i-N Schottky, MPS, diode. It should be noted however that the present disclosure is not limited to these devices as aspects of the present disclosure are equally applicable to MOSFETs, Schottky barriers, and PN diodes.

When forming an MPS diode, the method may further comprise forming, by ion implantation, a current spreader of the first charge type in the active area of the MPS diode. This current spreader can be formed before forming the one or more inner wells of the second charge type.

The method may further comprise arranging a first conductive layer assembly comprising one or more conductive layers, such as metals, on an upper side of the semiconductor body, wherein one or more conductive layers of the first conductive layer assembly form a plurality of Schottky contacts with the epitaxial layer or, in so far as applicable, with the current spreader, and wherein one or more conductive layers of the conductive layer assembly form a plurality of Ohmic contacts with the plurality of inner wells of the second charge type, wherein the first conductive layer assembly forms a first contact of the MPS diode. Here, it is noted that for the formation of the Ohmic contacts the same or different conductive layer(s) may be used as for the formation of the Schottky contacts. In addition, the method may further comprise arranging a second conductive layer assembly comprising one or more conductive layers, such as metals, on a lower side of the semiconductor body, wherein the second conductive layer assembly forms a second contact of the MPS diode.

According to aspects of the present disclosure, several distinct embodiments are possible among which in a first embodiment only the ion implantation for forming the JTE border is used for doping at least some of the inner wells of the second charge type. In a second embodiment, only the ion implantation for forming the further JTE border is used for doping at least some of the inner wells of the second charge type. In a third embodiment, only the ion implantation for forming the JTE rings is used for doping at least some of the inner wells of the second charge type. In a fourth embodiment, both the ion implantation for forming the JTE border and the ion implantation for forming the JTE rings are used for doping at least some of the inner wells of the second charge type. In a fifth embodiment, both the ion implantation for forming the further JTE border and the ion implantation for forming the JTE rings are used for doping at least some of the inner wells of the second charge type. In a sixth embodiment, both the ion implantation for forming the JTE border and the ion implantation for forming the further JTE border are used for doping at least some of the inner wells of the second charge type. In a seventh embodiment, the ion implantation for forming the JTE border, the implantation for forming the further JTE border, and the ion implantation for forming the JTE rings are used for doping at least some of the inner wells of the second charge type.

According to a further aspect of the present disclosure a semiconductor power device is provided that comprises a conductive substrate and an epitaxial layer of a first charge type grown on the conductive substrate. The semiconductor power device further comprises one or more inner wells of a second charge type different from the first charge type in an active area of the semiconductor power device. A termination area of the semiconductor power device separated from the inner wells comprises a junction termination extension, JTE, border of a second charge type, optionally a further JTE border of the second charge type that partially overlaps the JTE border, and optionally a plurality of junction termination extension JTE rings of a second charge type at least partially arranged in the JTE border and/or further JTE border.

At least some of the inner wells of the second charge type have a dopant concentration profile in a direction perpendicular to a top surface of the semiconductor body and towards the semiconductor substrate that displays a step in dopant concentration that corresponds to an dopant concentration that is associated with an ion implantation step for forming the JTE border, the further JTE border, or the plurality of JTE rings.

The semiconductor power device may comprise a Merged P-i-N Schottky, MPS, diode, a MOSFET, a Schottky barrier, or a PN diode. When the semiconductor power device comprises an MPS diode, it preferably comprises a current spreader of the first charge type in the active area. Additionally or alternatively, a depth of the one or more wells of the second charge type may be greater than a depth of the JTE border. Additionally or alternatively, a depth of the JTE border may be greater than a depth of the further JTE border. Additionally or alternatively, a depth of the further JTE border and/or JTE border may be greater than a depth of the plurality of JTE rings.

### DESCRIPTION OF THE DRAWINGS

Next, the present disclosure will be described in more detail with reference to the appended drawings, wherein:
FIG. 1 illustrates a cross-sectional view and a top view of an MPS diode known in the art;
FIG. 2 illustrates the doping profile corresponding to the cross-sectional view of figure 1;
FIG. 3 illustrates cross-sectional views of further MPS diodes known in the art;
FIG. 4 illustrates cross-sectional views of different MPS diodes according to aspects of the present disclosure in which a JTE border, and optionally a further JTE border, are used;
FIG. 5 illustrates cross-sectional views of different MPS diodes according to aspects of the present disclosure in which a JTE border and JTE rings are used;
FIG. 6 illustrates a doping profile through an inner well of an embodiment of an MPS diode in accordance with an aspect of the present disclosure;
FIG. 7 illustrates examples of a first ion implantation masking layer and a second ion implantation masking layer in accordance with an aspect of the present disclosure; and
FIG. 8 illustrates a method for manufacturing a semiconductor power device in accordance with aspects of the present invention.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

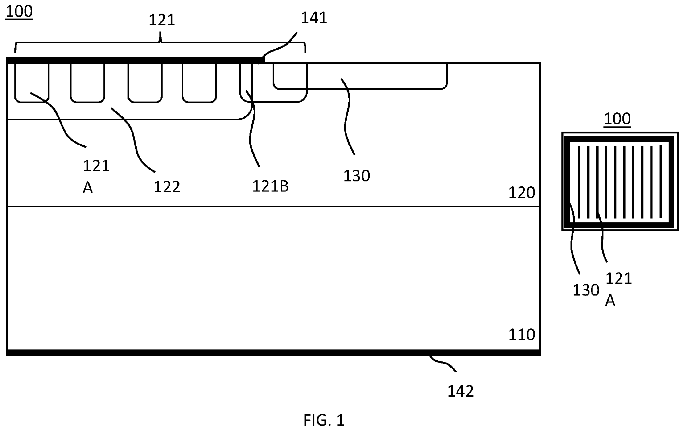

Figure 1 illustrates a known SiC MPS diode 100 comprising a semiconductor body that includes an n+-type SiC substrate 110 having a dopant concentration in the range between 5E18 and 5E19 #/cm3. The semiconductor body further includes an n-type epitaxial layer 120 that has been grown on SiC substrate 110 having a dopant concentration in the range between 6E15 and 2E16 #/cm3. Inside epitaxial layer 120 a plurality of p-type wells 121 has been formed using ion implantation. Plurality of wells 121 includes a plurality of inner wells 121A and an outer well 121B. Outer well 121B is relatively wide compared to inner wells 121A. A dopant concentration of wells 121A, 121B lies in a range between 8E17 and 3E18 #/cm3. The dopant concentration of outer well 121B referred to corresponds to the region thereof that is indicated by reference number 121B. Typically, outer well 121B has the same dopant concentration as inner wells 121A as it is normally defined by the same masking layer as inner wells 121A.

An n-type current spreader 122 is formed inside epitaxial layer 120. A dopant concentration of current spreader 122 lies in a range between 1E16 and 6E16 #/cm3. Current spreader 122 largely defines the active area of MPS diode 100. Next to the active area, a termination area is formed. In figure 1, the termination area comprises a p-type JTE border 130 that partially overlaps outer well 121B. A dopant concentration of JTE border 130 lies in a range between 1E17 and 5E17 #/cm3.

A conductive layer assembly 141 forms a first contact of MPS diode 100. This assembly may comprise one or more conductive layers, such as metal layers. Conductive layer assembly 141 forms Schottky contacts with current spreader 122 and Ohmic contacts with wells 121. To reduce contact resistance, wells 121 may comprise a highly doped p-type contact region near the surface of the semiconductor body (not shown). A further conductive layer assembly 142 comprising one or more conductive layers is arranged on the backside of the semiconductor body and forms a second contact of MPS diode 100.

MPS diode 100 may comprise many more layers, such as passivation layers. Such layers are known in the art and have been omitted for illustrative purposes.

The top view in figure 1, right, illustrates that JTE border 130 encloses the plurality of inner wells 121A.

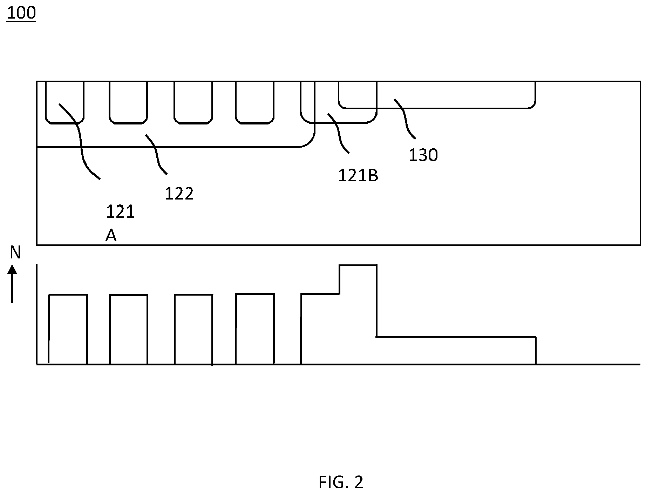

Figure 2 illustrates the p-type dopant concentration across the cross section of MPS diode 100. In figure 2, top, substrate 110 and conductive layer assemblies 141, 142 are omitted. The graph in figure 2, bottom, illustrates that a dopant concentration in outer well 121B has been partially increased due to the fact that outer well 121B has been partially exposed to two ion implantation steps, namely one step for forming outer well 121B and one step for forming JTE border 130.

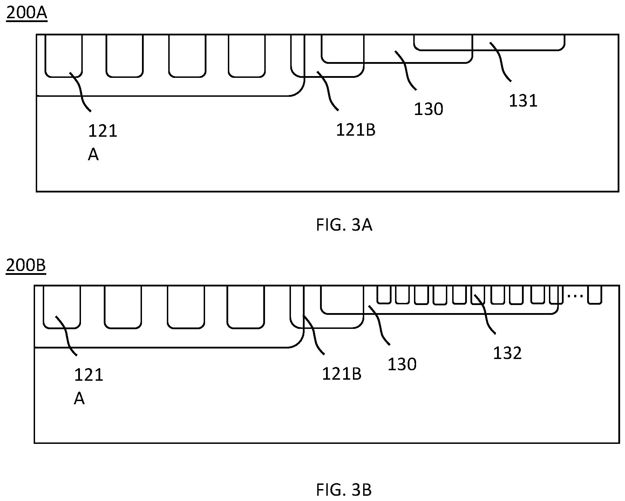

Figures 3A and 3B illustrate further examples of known MPS diodes 200A, 200B that differ from MPS diode 100 in the way the termination area is formed. In MPS diode 200A, a further p-type JTE border 131 is formed of which a dopant concentration lies in a range between 5E16 and 1E17 #/cm3 and that encloses the plurality of inner wells 121A similar to what is shown in figure 1, right. In MPS diode 200B, a plurality of p-type JTE rings 132 is formed of which a dopant concentration lies in a range between 1E17 and 1E18 #/cm3. JTE rings 132 are formed to at least partially overlap JTE border 130 and enclose the plurality of inner wells 121A similar to what is shown in figure 1, right.

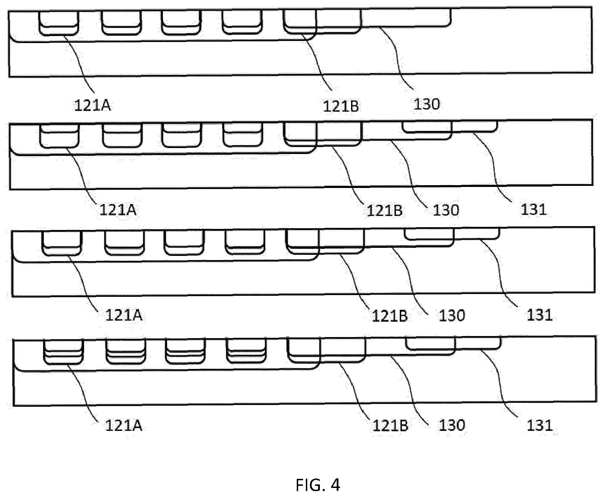

Next, aspects of the present disclosure will be described referring to figures 4-8.

In figure 4, four examples are shown wherein the ion implantation step used for forming JTE border 130 and/or further JTE border 131 have also been used for increasing a dopant concentration of inner wells 121A.

In the top figure, only a JTE border 130 is formed. However, when forming JTE border 130, ions were also implanted in inner wells 121A and outer well 121B or, to put it more general, in the region where inner wells 121A and outer well 121B have been or will be formed. This latter distinction is important because embodiments are possible in which JTE border 130 is formed prior to or after forming wells 121A. In both cases, i.e. wells 121A being formed before or after JTE border 130, proper alignment is important.

In the second figure from the top, both a JTE border 130 and a further JTE border 131 are formed. However, only the ion implantation step for forming further JTE border 131 has been used for increasing the dopant concentration of inner wells 121A. It is noted that the dopant concentration of outer well 121B has not been increased by the ion implantation step for forming further JTE border 131. The dopant concentration of outer well 121B has however been increased, contrary to that of inner wells 121A, by the ion implantation step for forming JTE border 130.

In the third figure from the top, both a JTE border 130 and a further JTE border 131 are formed. In this case, only the ion implantation step for forming JTE border 130 has been used for increasing the dopant concentration of inner wells 121A and outer well 121B.

In the bottom figure, both the ion implantation step for forming JTE border 130 and the ion implantation step for forming further JTE border 131 have been used for increasing the dopant concentration of inner wells 121A. In this case, the dopant concentration of outer well 121B may only have been increased due to the ion implantation step for forming JTE border 130.

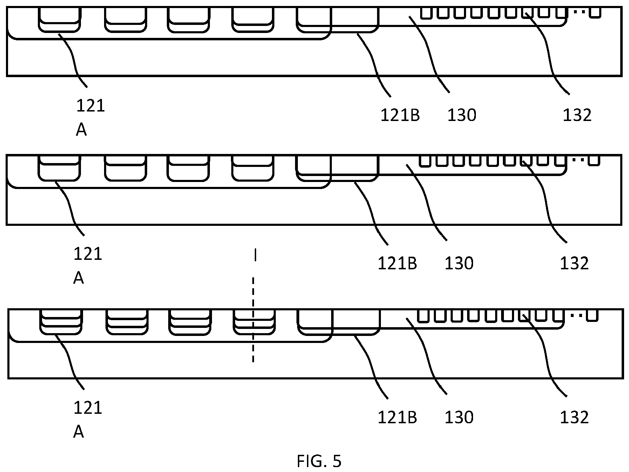

In figure 5, three examples are shown wherein the ion implantation step used for forming JTE border 130 and/or JTE rings 132 have also been used for increasing a dopant concentration of inner wells 121A.

In the top figure, only the ion implantation step for forming JTE border 130 has been used for increasing the dopant concentration of inner wells 121A and outer well 121B. In the center figure, only the ion implantation step for forming JTE rings 132 has been used for increasing the dopant concentration of inner wells 121A. The dopant concentration of outer well 121B was not increased due to this ion implantation step.

In the bottom figure, both the ion implantation step for forming JTE border 130 and the ion implantation step for forming JTE rings 132 have been used for increasing the dopant concentration of inner wells 121A. Again, the dopant concentration of outer well 121B was only increased due to the ion implantation step for forming JTE border 130.

Other embodiments are equally possible. The table below illustrates various combinations that can be realized when using ion implantation for forming JTE border 130, further JTE border 131, and JTE rings 132. In the table, a plus sign "+" and a minus sign "-" indicate that a particular ion implantation step has or has not been used for increasing a dopant concentration of inner wells 121A.

| formation step JTE border 130 | formation step further JTE border 131 | formation step JTE rings 132 |
|---|---|---|
| + | - | - |
| - | + | - |
| - | - | + |
| + | + | - |
| - | + | + |
| + | - | + |
| + | + | + |

In other embodiments, multiple further JTE borders may be used, which increases the number of possibilities even more.

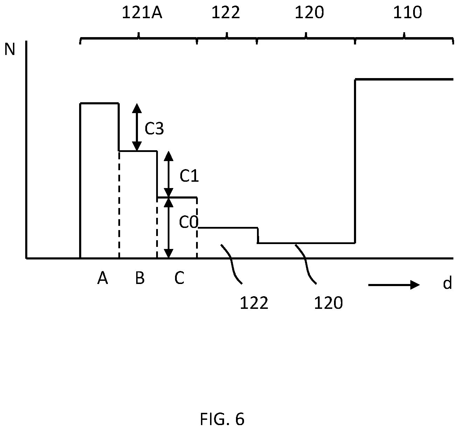

Figure 6 illustrates a dopant concentration N in #/cm3 along line I in figure 5, bottom. Here, three different regions A-C can be distinguished inside inner wells 121A. Region A of inner wells 121A has been subjected to three different ion implantation steps, i.e. a first step for forming wells 121A, a second step for forming JTE border 130, and a third step for forming JTE rings 132. Region B of wells 121A has been subjected to two different ion implantation steps, i.e. the first step for forming wells 121A, and the second step for forming JTE border 130. Region C of wells 121A has only been subjected to the first step for forming wells 121A.

In figure 6, a difference in dopant concentration can be observed between the various regions, which in figure 6 is idealized in the sense that each region shows a distinct level of dopant concentration without any variation over the region. Using this idealization, a dopant concentration associated with the third ion implantation step for forming JTE rings 132 corresponds to C3. This dopant concentration therefore corresponds to the dopant concentration inside JTE rings 132 and corresponds to the difference between regions A and B. Similarly, a dopant concentration associated with the second ion implantation step for forming JTE border 130 corresponds to C1. This dopant concentration corresponds to the dopant concentration inside JTE border 130 and corresponds to the difference between regions B and C. A dopant concentration associated with the first ion implantation step for forming inner wells 121A corresponds to C0. This dopant concentration corresponds to the dopant concentration inside region C of inner wells 121A.

It is noted that figure 6 further illustrates the dopant concentration of n-type current spreader 122, n-type epitaxial layer 120, and n+-substrate 110.

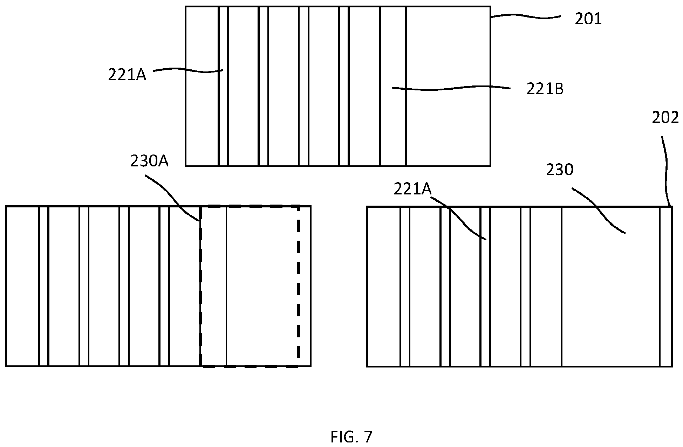

Figure 7 illustrates a part of a first ion implantation masking layer 201 in top view showing openings 221A for forming inner wells 121A and an opening 221B for forming outer well 121B. After using this masking layer, which can be made of photoresist, oxides, or nitrides, it can be modified for the manufacturing of a second ion implantation masking layer 202 by which a dopant concentration of inner wells 121A can be increased while simultaneously forming a JTE structure.

Figure 7, bottom left, illustrates a region 230A on first ion implantation masking layer 201 that corresponds to the combination of outer well 121B and JTE border 130 in the final device. To modify first ion implantation masking layer 201, a layer of masking material such as photoresist is arranged on first ion implantation masking layer 201. Next, the layer of masking material is patterned such that region 230A is opened. As a next step, an opening is created in first ion implantation masking layer 201 by etching away the masking material of first ion implantation masking layer 201 that is exposed by the created opening. This results in the formation of second ion implantation masking layer 202 as shown in figure 7, bottom right. When using second ion implantation masking layer 202, the structure of figure 4, top, is obtained.

Figure 7 illustrates a case in which the second ion implantation masking layer is obtained by modifying the first ion implantation masking layer while it is still arranged on the semiconductor body. In other embodiments, separately arranged ion implantation masking layers can be used. An exemplary process in which separately arranged ion implantation masking layers are used will be described next.

As a first step, for the formation of the first ion implantation masking layer, a layer of masking material is deposited on the semiconductor body. This layer is patterned to create first openings for the formation of the one or more inner wells. Patterning can be performed using well-known techniques comprising photolithography and etching.

As a next step, an ion implantation process is performed using the created first ion implantation masking layer. This will create the one or more inner wells and the outer well in the semiconductor body.

As a next step, the first ion implantation masking layer is removed from the semiconductor body and a new layer of masking material is deposited on the semiconductor body for the formation of a JTE structure such as a JTE border. This newly deposited layer of masking material is patterned to create a second ion implantation masking layer that comprises second openings that correspond to the JTE border and one or more first openings that correspond to the inner wells of which the dopant concentration should be increased. Next, an ion implantation process is performed using the created second ion implantation masking layer. This implantation will result in the formation of the JTE structure and in the enhancement of the dopant concentration in at least some of the inner wells.

It is noted that the depth of the various ion implantation steps may differ as illustrated in figures 4-6 although this is not mandatory. In some embodiments, the depth of the ion implantation step associated with the formation of wells 121A, 121B, is greater than the depth of the ion implantation step associated with the formation of JTE border 130. This latter depth can be greater than the depth of the ion implantation associated with the formation of JTE rings 132.

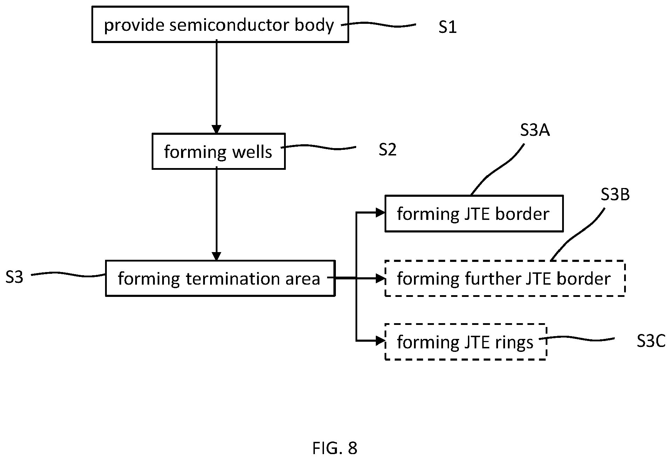

Figure 8 illustrates a method for manufacturing a semiconductor power device in accordance with aspects of the present invention. This method comprises a step S1 of providing a semiconductor body comprising a conductive substrate and an epitaxial layer of a first charge type grown on the conductive substrate. It further comprises a step S2 of forming, by ion implantation, one or more inner wells of a second charge type different from the first charge type in an active area of the semiconductor power device, and a step S3 of forming a termination area of the semiconductor power device separated from the inner wells. Here, step S3 comprises a step S3A of forming a junction termination extension, JTE, border of a second charge type by ion implantation. Step S3 may optionally comprise a step S3B of additionally forming by ion implantation a further JTE border of the second charge type that partially overlaps the JTE border in the manufactured semiconductor power device and/or a step S3C of additionally forming a plurality of junction termination extension JTE rings of the second charge type at least partially arranged in the JTE border and/or further JTE border. It should be noted that step S2 can be performed before or after step S3. Similarly, the order in which any of the steps S3A, S3B, S3C is performed can be varied. Furthermore, at least one of the ion implantation for forming the JTE border, the ion implantation for forming the further JTE border, and the ion implantation for forming the JTE rings is used for increasing a dopant concentration of at least some of the inner wells of the second charge type.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A method for manufacturing a semiconductor power device, comprising:
providing a semiconductor body comprising a conductive substrate and an epitaxial layer of a first charge type grown on the conductive substrate;
forming, by ion implantation, one or more inner wells of a second charge type different from the first charge type in an active area of the semiconductor power device;
forming a termination area of the semiconductor power device separated from the one or more inner wells by forming a junction termination extension, JTE, border of a second charge type by ion implantation, and optionally by additionally forming by ion implantation at least one of:
a further JTE border of the second charge type that partially overlaps the JTE border in the manufactured semiconductor power device;
a plurality of junction termination extension JTE rings of the second charge type at least partially arranged in the JTE border and/or further JTE border in the manufactured semiconductor power device;
wherein at least one of the ion implantation for forming the JTE border, the ion implantation for forming the further JTE border, and the ion implantation for forming the JTE rings is used for increasing a dopant concentration of at least some of the one or more inner wells of the second charge type.

2. The method according to claim 1, wherein the step of forming the one or more inner wells of the second charge type is performed using a first ion implantation masking layer, and wherein the step of ion implantation for increasing the dopant concentration of at least some of the one or more inner wells of the second charge type is performed using a second ion implantation masking layer that is aligned with or at least partially identical to the first ion implantation masking layer.

3. The method according to claim 2, wherein the first ion implantation masking layer comprises one or more first openings through which ions may penetrate the semiconductor body thereby forming the one or more inner wells;
the method further comprising constructing the second ion implantation masking layer by modifying the first ion implantation masking layer, after having formed the one or more inner wells and while the first ion implantation masking layer is still present on the semiconductor body, by creating second openings in the first ion implantation masking layer that correspond to the JTE border, further JTE border and/or JTE rings to be formed.

4. The method according to claim 3, comprising modifying the second ion implantation masking layer by covering some of the one or more first openings to prevent the dopant concentration of the associated inner wells to be increased when performing ion implantation using the modified second ion implantation layer.

5. The method according to claim 2, wherein the ion implantation for forming the one or more inner wells of the second charge type, and the ion implantation for forming the JTE border, the optional JTE rings, and/or the optional further JTE border are performed using different ion implantation masking layers that are separately arranged on the semiconductor body.

6. The method according to any of the previous claims, further comprising forming an outer well simultaneously with forming the one or more inner wells, wherein the outer well partially overlaps with the JTE border in the manufactured semiconductor power device, and wherein the outer well is preferably wider than the one or more inner wells.

7. The method according to any of the previous claims, wherein said at least one of the ion implantation for forming the JTE border, the ion implantation for forming the further JTE border, and the ion implantation for forming the JTE rings is used for increasing a dopant concentration of doping all the inner wells of the second charge type.

8. The method according to any of the previous claims, wherein a maximum depth d0 of the one or more inner wells is greater than a maximum depth d1 of the JTE border, greater than a maximum depth d2 of the further JTE border, and greater than a maximum depth d3 of the JTE rings; and/or
wherein the maximum depth d1 of the JTE border is greater than the maximum depth d2 of the further JTE border, and greater than the maximum depth d3 of the JTE rings; and/or
wherein the maximum depth d2 of the further JTE border is greater than or equal to the maximum depth d3 of the JTE rings;
wherein 1.2 <= d0 <= 0.8 micrometer, 0.8 <= d1 <= 0.6 micrometer, 0.6 <= d2 <= 0.4 micrometer, 0.4 <= d3 <= 0.2 micrometer; and/or
wherein d1 lies in a range between 60 and 80 percent of d0, d2 in a range between 40 and 60 percent of d0, and d3 in a range between 20 and 40 percent of d0.

9. The method according to any of the previous claims, wherein the ion implantation step for forming the one or more inner wells raises the dopant concentration by an amount C0 in the range in between 8E17 and 3E18 #/cm3;
wherein the ion implantation step for forming the JTE border may raise the dopant concentration by an amount C1 in the range in between 1E17 and 5E17 #/cm3;
wherein the ion implantation step for forming the further JTE border raises the dopant concentration by an amount C2 in the range in between 5E16 and 1E17 #/cm3;
wherein the ion implantation step for forming the JTE rings raises the dopant concentration by an amount C3 in the range in between 1E17 and 1E18 #/cm3.

10. The method according to any of the previous claims, wherein the semiconductor power device comprises a Merged P-i-N Schottky, MPS, diode.

11. The method according to claim 10, further comprising forming, by ion implantation, a current spreader of the first charge type in the active area of the MPS diode, wherein the current spreader is preferably formed before forming the one or more inner wells of the second charge type.

12. The method according to claim 10 or 11, further comprising arranging a first conductive layer assembly comprising one or more conductive layers, such as metals, on an upper side the semiconductor body, wherein one or more conductive layers of the first conductive layer assembly form a plurality of Schottky contacts with the epitaxial layer or, in so far as depending on claim 9, with the current spreader, and wherein one or more conductive layers of the conductive layer assembly form a plurality of Ohmic contacts with the plurality of inner wells of the second charge type, wherein the first conductive layer assembly forms a first contact of the MPS diode;
the method further comprising arranging a second conductive layer assembly comprising one or more conductive layers, such as metals, on a lower side of the semiconductor body, wherein the second conductive layer assembly forms a second contact of the MPS diode.

13. The method according to any of the previous claims, wherein:
only the ion implantation for forming the JTE border is used for doping at least some of the inner wells of the second charge type; or
only the ion implantation for forming the further JTE border is used for doping at least some of the inner wells of the second charge type; or
only the ion implantation for forming the JTE rings is used for doping at least some of the inner wells of the second charge type; or
both the ion implantation for forming the JTE border and the ion implantation for forming the JTE rings are used for doping at least some of the inner wells of the second charge type; or
both the ion implantation for forming the further JTE border and the ion implantation for forming the JTE rings are used for doping at least some of the inner wells of the second charge type; or
both the ion implantation for forming the JTE border and the ion implantation for forming the further JTE border are used for doping at least some of the inner wells of the second charge type; or
the ion implantation for forming the JTE border, the implantation for forming the further JTE border, and the ion implantation for forming the JTE rings are used for doping at least some of the inner wells of the second charge type.

14. A semiconductor power device, comprising:
a semiconductor body comprising a conductive substrate and an epitaxial layer of a first charge type grown on the conductive substrate;
one or more inner wells of a second charge type different from the first charge type in an active area of the semiconductor power device;
a termination area of the semiconductor power device separated from the inner wells and comprising a junction termination extension, JTE, border of a second charge type, optionally a further JTE border of the second charge type that partially overlaps the JTE border, and optionally a plurality of junction termination extension JTE rings of a second charge type at least partially arranged in the JTE border and/or further JTE border;
wherein at least some of the inner wells of the second charge type have a dopant concentration profile in a direction perpendicular to a top surface of the semiconductor body and towards the semiconductor substrate that displays a step in dopant concentration that corresponds to an dopant concentration that is associated with an ion implantation step for forming the JTE border, the further JTE border, or the plurality of JTE rings.

15. The semiconductor power device according to claim 14, wherein the semiconductor power device comprises a Merged P-i-N Schottky, MPS, diode, a MOSFET, a Schottky barrier, or a PN diode;
wherein, when the semiconductor power device comprises an MPS diode, the MPS diode preferably comprises a current spreader of the first charge type in the active area; and/or
wherein a depth of the one or more wells of the second charge type is greater than a depth of the JTE border; and/or
wherein a depth of the JTE border is greater than a depth of the further JTE border; and/or
wherein a depth of the further JTE border and/or JTE border is greater than a depth of the plurality of JTE rings.
